# EUROPEAN PATENT SPECIFICATION

(11) **EP 3 098 864 B1**
(45) Date of publication and mention of the grant of the patent: **15.05.2019**
(21) Application number: 15740304.9
(22) Date of filing: 21.01.2015
(51) Int. Cl.: H01L 35/30, H01L 35/32, H02N 11/00

(54) **THERMOELECTRIC CONVERSION MODULE**
THERMOELEKTRISCHES UMWANDLUNGSMODUL
MODULE DE CONVERSION THERMOÉLECTRIQUE

(30) Priority: 22.01.2014 JP 2014009463
(43) Date of publication of application: 30.11.2016
(73) Proprietor: Atsumitec Co., Ltd., Hamamatsu-shi, Shizuoka 433-8118 (JP)
(72) Inventor: UCHIYAMA, Naoki, Hamamatsu-shi Shizuoka 433-8118 (JP)
(74) Representative: MERH-IP Matias Erny Reichl Hoffmann Patentanwälte PartG mbB
(86) International application number: PCT/JP2015/051563
(87) International publication number: WO 2015/111628

(56) References cited:
- WO-A1-2013/065856
- JP-A- 2009 260 256
- JP-A- 2012 019 205
- US-A1- 2009 038 667
- US-B1- 6 274 803

## Description

### Technical Field

The present invention relates to a thermoelectric conversion module that thermoelectrically generates heat by a Seebeck effect.

### Background Art

A thermoelectric conversion module is a module including a thermoelectric conversion element capable of converting thermal energy to electric energy by the Seebeck effect. By utilizing such an energy conversion property, waste heat discharged from industrial/consumer processes and moving bodies can be converted to effective power so that the thermoelectric conversion module and the thermoelectric conversion element configuring the thermoelectric conversion module are drawing attention as an energy saving technology in consideration of an environmental problem.

Such a thermoelectric conversion module is configured generally by joining a plurality of thermoelectric conversion elements (p-type semiconductors and n-type semiconductors) by electrodes. Such a thermoelectric conversion module is disclosed in Patent Document 1, for example. The thermoelectric conversion module disclosed in Patent Document 1 includes a pair of substrates, a plurality of thermoelectric conversion elements whose first ends are electrically connected with first electrodes arranged on one of the substrates and second ends are electrically connected to second electrodes arranged on the other substrate, and connection parts that electrically connect the first electrode electrically connected to the thermoelectric conversion element to the second electrode electrically connected to an adjacent thermoelectric conversion element.

Furthermore JP 2012-019205 A describes a thermoelectric conversion module having covering members of different thermal conductivities.

US 6274803 B1 describes a thermoelectric module with improved heat-transfer efficiency.

### Prior Art Document

### Patent Document

Patent Document 1: Japanese Patent Laid-Open No. 2013-115359

### Summary of the Invention

### Problems to be solved by the Invention

However, in a structure of the thermoelectric conversion module disclosed in Patent Document 1, due to dimensional dispersion of the thermoelectric conversion element, joining strength of the thermoelectric conversion element and the electrode varies and strength declines as the entire thermoelectric conversion module. In addition, heat is discharged also in an exposed thermoelectric conversion element, a temperature difference between the electrodes becomes dispersed and small, and it is difficult to improve thermoelectric conversion efficiency.

The present invention is implemented in consideration of such a problem, and an object of the present invention is to provide a thermoelectric conversion module that has excellent strength and thermoelectric conversion efficiency and is capable of performing stable thermoelectric power generation.

### Means for Solving the Problems

In order to achieve the above-described object, a thermoelectric conversion module of the present invention includes a plurality of thermoelectric conversion elements arranged side by side, first electrodes joined to first ends of the thermoelectric conversion elements and electrically connecting the first ends of the adjacent thermoelectric conversion elements to each other, second electrodes joined to second ends of the thermoelectric conversion elements and electrically connecting the second ends of the adjacent thermoelectric conversion elements to each other, a cooling mechanism that cools the first electrodes, a first covering member that covers the first electrodes and includes the cooling mechanism, and a second covering member that covers at least part of each of the plurality of thermoelectric conversion elements and the second electrode, and the second covering member has a thermal conductivity lower than that of the first covering member.

### Advantageous Effects of the Invention

According to the thermoelectric conversion module relating to the present invention, stable thermoelectric power generation can be performed with excellent thermoelectric conversion efficiency while improving strength of the module itself.

### Brief Description of the Drawings

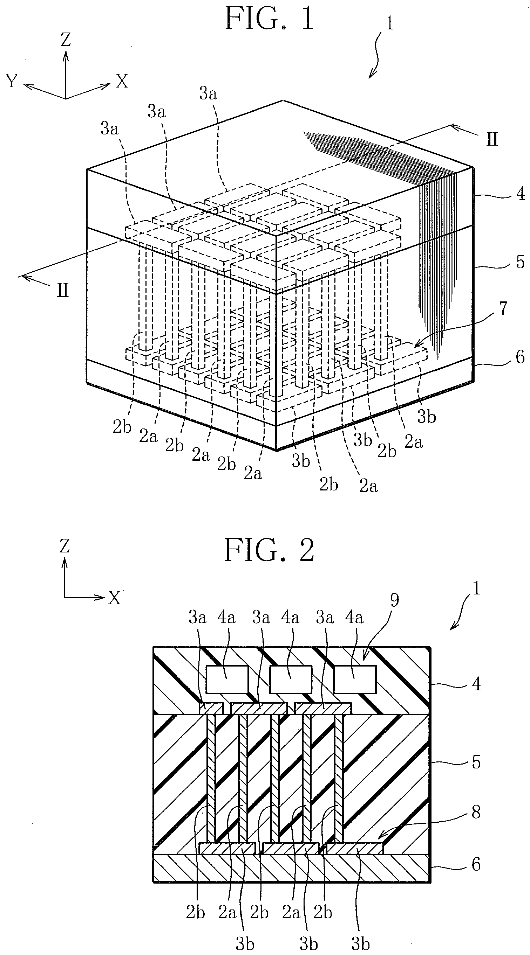

FIG. 1 is a perspective view of a thermoelectric conversion module relating to an embodiment.FIG. 2 is a sectional view along a line II-II in FIG. 1.

### Mode for Carrying out the Invention

Hereinafter, with reference to the drawings, a mode for carrying out the thermoelectric conversion module by the present invention will be described in detail based on an embodiment. In addition, drawings used when describing the embodiment all schematically illustrate the thermoelectric conversion module by the present invention or configuration members thereof, are partially emphasized, enlarged, reduced or omitted or the like in order to deepen understandings, and sometimes do not accurately indicate scales and shapes or the like of the individual configuration members. Further, various numerical values used in the embodiment all indicate examples and can be variously changed as needed.

### <Embodiment>

### (Structure of thermoelectric conversion module)

Hereinafter, while referring to FIG. 1 and FIG. 2, the structure of a thermoelectric conversion module 1 relating to the present embodiment will be described. Here, FIG. 1 is a perspective view of the thermoelectric conversion module 1 relating to the present embodiment, and FIG. 2 is a sectional view along a line II-II in FIG. 1. Then, one direction in FIG. 1 is defined as an X direction, directions orthogonal to the X direction are defined as a Y direction and a Z direction, and in particular a height direction of the thermoelectric conversion module 1 is defined as the Z direction.

As can be seen from FIG. 1 and FIG. 2, the thermoelectric conversion module 1 relating to the present embodiment includes a plurality of first thermoelectric conversion elements 2a and second thermoelectric conversion elements 2b arranged side by side, first electrodes 3a and second electrodes 3b provided on ends of the first thermoelectric conversion elements 2a and the second thermoelectric conversion elements 2b, a first covering member 4 provided so as to cover the first electrodes 3a, a second covering member 5 provided so as to cover the first thermoelectric conversion elements 2a and the second thermoelectric conversion elements 2b, and a support substrate 6 provided so as to support the second electrodes 3b.

In the present embodiment, the first thermoelectric conversion elements 2a are configured from an N-type semiconductor material, and the second thermoelectric conversion elements 2b are configured from a P-type semiconductor material. Then, the first thermoelectric conversion elements 2a and the second thermoelectric conversion elements 2b are arranged alternately in a matrix shape, and are electrically connected through the first electrodes 3a and the second electrodes 3b.

In the present embodiment, the first thermoelectric conversion elements 2a and the second thermoelectric conversion elements 2b are formed into a rectangular parallelepiped shape whose one side is about 3 mm and length is 5 mm to 10 mm; however, without being limited to such a shape, they may be a columnar shape for example.

The first electrodes 3a and the second electrodes 3b have the same shape (planar shape) and are formed of a copper plate, for example. Also, as illustrated in FIG. 1, for the first electrodes 3a, an orientation of a long side direction is adjusted so that 5 pieces arranged at both ends in the X direction (more specifically, 2 pieces at the end in a +X direction and 3 pieces at the end in a -X direction) extend in the Y direction, and the orientation of the long side direction is adjusted so that 12 pieces held between the 5 pieces extend in the X direction. On the other hand, for all the second electrodes 3b (18 pieces), the orientation of the long side direction is adjusted so as to extend in the X direction. Further, to both ends on surfaces of the first electrodes 3a and the second electrodes 3b, the first thermoelectric conversion elements 2a and the second thermoelectric conversion elements 2b are joined. That is, the first electrodes 3a and the second electrodes 3b are arranged so as to hold the first thermoelectric conversion elements 2a and the second thermoelectric conversion elements 2b therebetween.

By such an arrangement relation of the first thermoelectric conversion elements 2a, the second thermoelectric conversion elements 2b, the first electrodes 3a and the second electrodes 3b, the first thermoelectric conversion elements 2a and the second thermoelectric conversion elements 2b are connected in series. More specifically, as illustrated in FIG. 1 and FIG. 2, a series connection circuit from an external connection part 7 to an external connection part 8 where the thermoelectric conversion elements are not joined in the second electrodes 3b is formed. Here, though not illustrated in FIG. 1 and FIG. 2, to the external connection parts 7 and 8, external connection wiring is joined by a joining member such as solder.

Note that the first electrodes 3a and the second electrodes 3b may be formed of other conductive materials (a metal material such as aluminum for example) without being limited to the copper plate. In addition, quantities and shapes of the first electrodes 3a and the second electrodes 3b are not limited to the above-described contents and can be appropriately changed according to the first thermoelectric conversion elements 2a and the second thermoelectric conversion elements 2b (that is, magnitude of electromotive force). Further, the first electrodes 3a and the second electrodes 3b may be disposed so as to connect the first thermoelectric conversion elements 2a and the second thermoelectric conversion elements 2b in parallel.

As can be seen from FIG. 1 and FIG. 2, the first covering member 4 covers the surfaces of the first electrodes 3a so as to embed the first electrodes 3a. Also, the first covering member 4 is formed of a resin having an insulating property, and a metal material such as aluminum, copper or aluminum nitride which functions as a thermally conductive material is mixed in the resin. By such a structure, the first covering member 4 has a relatively high thermal conductivity, and maintains an excellent electric insulation state around the first electrodes 3a.

In addition, as illustrated in FIG. 2, voids 4a are formed in the first covering member 4. Cooling water is supplied to the voids 4a, and the periphery of the voids 4a can be cooled by circulating the cooling water. That is, a cooling mechanism 9 is formed in the first covering member 4. By forming such a cooling mechanism 9 in the first covering member 4, the first electrodes 3a can be cooled. In particular, since the first covering member 4 has the relatively high thermal conductivity, a cooling effect by the cooling mechanism 9 can be increased (that is, cooling can be efficiently performed). When the first electrodes 3a are cooled in this way, a temperature difference is generated between the first electrodes 3a and the second electrodes 3b, and the electromotive force is generated.

Note that, in the present embodiment, cooling of the first electrodes 3a is made possible by forming the voids 4a in the first covering member 4 and supplying the cooling water into the voids 4a, however, a plurality of projections may be formed instead of the voids 4a and the first covering member 4 may be made to function as a heatsink. That is, not a water-cooled cooling mechanism as in the present embodiment but an air-cooled cooling mechanism may be used.

As can be seen from FIG. 1 and FIG. 2, the second covering member 5 covers the first thermoelectric conversion elements 2a, the second thermoelectric conversion elements 2b, and the second electrodes 3b so as to embed the first thermoelectric conversion elements 2a, the second thermoelectric conversion elements 2b, and the second electrodes 3b. Also, the second covering member 5 is formed of a resin having the insulation property, and a heat insulation material is mixed in the resin. For example, as the heat insulation material that forms the second covering member 5, a fiber-based heat insulation material such as glass wool and a foam-based heat insulation material such as polystyrene foam can be used.

By such a structure, the second covering member 5 has the thermal conductivity lower than that of the first covering member 4, and has a function of suppressing heat radiation in the first thermoelectric conversion elements 2a, the second thermoelectric conversion elements 2b, and the second electrodes 3b. Then, the second covering member 5 can increase the temperature difference between the first electrodes 3a and the second electrodes 3b, maintain the temperature difference fixed, and cause to generate the larger electromotive force. In addition, the second covering member 5 maintains the excellent electric insulation state around the first thermoelectric conversion elements 2a, the second thermoelectric conversion elements 2b, and the second electrodes 3b.
In addition, since the first thermoelectric conversion elements 2a, the second thermoelectric conversion elements 2b, and the second electrodes 3b are relatively strongly held by the second covering member 5, strength of the thermoelectric conversion module 1 itself can be improved. Further, since the first thermoelectric conversion elements 2a and the second thermoelectric conversion elements 2b are completely covered, damages and strains or the like of the first thermoelectric conversion elements 2a and the second thermoelectric conversion elements 2b can be prevented, and decline of thermoelectric conversion efficiency and reliability of the thermoelectric conversion module 1 itself can be suppressed. Then, since edges of joined interfaces of the first thermoelectric conversion elements 2a and the second thermoelectric conversion elements 2b and the first electrodes 3a and the second electrodes 3b are not exposed, joining strength of the thermoelectric conversion elements and the electrodes can be improved, decline of the joining strength with aging can be suppressed, and generation of cracks at the joined interfaces can be prevented.
Note that, the second covering member 5 does not need to completely cover the first thermoelectric conversion elements 2a and the second thermoelectric conversion elements 2b, and may cover part of them. It is because, even in such a case, while generating the temperature difference between the first electrodes 3a and the second electrodes 3b, the temperature difference can be kept fixed and the strength of the thermoelectric conversion module 1 itself can be improved.
In addition, in the second covering member 5, similarly to the first covering member 4, a material that functions as the thermally conductive material may be mixed.
Even in such a case, the second covering member 5 needs to have the thermal conductivity lower than that of the first covering member 4.

Further, the second covering member 5 may be provided with voids similarly to the first covering member 4 to supply the cooling water. That is, the cooling mechanism may be formed also in the second covering member 5. By such a configuration, the temperature difference between the first electrodes 3a and the second electrodes 3b can be kept fixed with higher accuracy.

Then, in the present embodiment, a main material of the first covering member 4 and the second covering member 5 is the resin, however, a material such as ceramics may be used. Even in such a case, the material that covers the second electrodes 3b needs to have the thermal conductivity lower than that of the material that covers the first electrodes 3a.

As illustrated in FIG. 2, the support substrate 6 is joined with the second electrodes 3b so as to support the second electrodes 3b. The support substrate 6 is configured from an insulation material, and for example, a general insulation substrate such as a glass epoxy substrate can be used.

### (Manufacturing method of the thermoelectric conversion module)

As a manufacturing method of the thermoelectric conversion module 1 relating to the present embodiment, between two punches that function as an electric pressurizing member configuring a manufacturing device, prepared first thermoelectric conversion elements 2a, second thermoelectric conversion elements 2b, first electrodes 3a and second electrodes 3b are arranged. Thereafter, a current is supplied while pressurizing the two punches toward the first thermoelectric conversion elements 2a, the second thermoelectric conversion elements 2b, the first electrodes 3a and the second electrodes 3b. Thus, the first thermoelectric conversion elements 2a and the second thermoelectric conversion elements 2b and the first electrodes 3a and the second electrodes 3b are diffusion-joined (plasma-joined), and the plurality of first thermoelectric conversion elements 2a and second thermoelectric conversion elements 2b are connected in series. Such electric pressurization is conducted inside a chamber of a vacuum, nitrogen gas or inert gas atmosphere.

Next, the first thermoelectric conversion elements 2a, the second thermoelectric conversion elements 2b, the first electrodes 3a and the second electrodes 3b in a joined state are mounted on the support substrate 6. More specifically, the second electrodes 3b are joined on a metal pattern formed on the support substrate 6 through a joining member such as solder to support the first thermoelectric conversion elements 2a, the second thermoelectric conversion elements 2b, the first electrodes 3a and the second electrodes 3b.

Next, the second covering member 5 is formed by general insertion molding, and the first covering member 4 is formed by similar insertion molding thereafter. Here, when forming the first covering member 4, the voids 4a are simultaneously formed by a mold or the like.

Through the processes above, the thermoelectric conversion module 1 is completed.

### (Effects of the present embodiment)

As described above, the thermoelectric conversion module 1 of the present embodiment includes the plurality of first thermoelectric conversion elements 2a and second thermoelectric conversion elements 2b arranged side by side, the first electrodes 3a that are joined to first ends of these thermoelectric conversion elements and electrically connect the first ends of the adjacent thermoelectric conversion elements to each other, the second electrodes 3b that are joined to second ends of these thermoelectric conversion elements and electrically connect the second ends of the adjacent thermoelectric conversion elements to each other, the cooling mechanism 9 that cools the first electrodes 3a, the first covering member 4 that covers the first electrodes 3a, and the second covering member 5 that covers these thermoelectric conversion elements. In addition, in the thermoelectric conversion module 1 of the present embodiment, the second covering member 5 has the thermal conductivity lower than that of the first covering member 4.

By such a structure of the thermoelectric conversion module 1, the temperature difference between the first electrodes 3a to be a low temperature side of the thermoelectric conversion module 1 and the second electrodes 3b to be a high temperature side can be kept fixed, and further, the excellent electric insulation state around the first thermoelectric conversion elements 2a, the second thermoelectric conversion elements 2b, the first electrodes 3a and the second electrodes 3b can be maintained so that the stable thermoelectric power generation can be performed.

Also, by covering and holding the first thermoelectric conversion elements 2a, the second thermoelectric conversion elements 2b, the first electrodes 3a and the second electrodes 3b by the first covering member 4 and the second covering member 5 of different thermal conductivities, these components are hardly affected by external force or the like, and the strength as the thermoelectric conversion module 1 itself is improved.

Further, since the thermal conductivity of the second covering member 5 is made lower than the thermal conductivity of the first covering member 4, while excellently cooling the first electrodes 3a positioned on the low temperature side, temperature decline in the first thermoelectric conversion elements 2a and the second thermoelectric conversion elements 2b can be suppressed. Thus, the stable thermoelectric power generation can be performed while improving the thermoelectric conversion efficiency of the thermoelectric conversion module 1.

In the thermoelectric conversion module 1 of the present embodiment, since the first covering member 4 is formed of the resin mixed with the metal material such as copper or aluminum nitride, the thermal conductivity becomes relatively high, and the first electrodes 3a can be cooled more excellently.

In the thermoelectric conversion module 1 of the present embodiment, since the second covering member 5 is formed of the resin mixed with the heat insulation material, the temperature decline in the first thermoelectric conversion elements 2a and the second thermoelectric conversion elements 2b can be suppressed further.

In the thermoelectric conversion module 1 of the present embodiment, since the second covering member 5 covers all of the plurality of first thermoelectric conversion elements 2a and second thermoelectric conversion elements 2b, and the second electrodes 3b, the temperature decline in the first thermoelectric conversion elements 2a and the second thermoelectric conversion elements 2b can be suppressed and the strength of the thermoelectric conversion module 1 itself can be improved.

### <Implementations of the present invention>

The thermoelectric conversion module relating to a first implementation of the present invention includes a plurality of thermoelectric conversion elements arranged side by side, a first electrode that is joined to first ends of the thermoelectric conversion elements and electrically connect the first ends of the adjacent thermoelectric conversion elements to each other, a second electrode that is joined to second ends of the thermoelectric conversion elements and electrically connect the second ends of the adjacent thermoelectric conversion elements to each other, a cooling mechanism that cools the first electrodes, a first covering member that covers the first electrodes, and a second covering member that covers at least part of each of the plurality of thermoelectric conversion elements, and the second covering member has a thermal conductivity lower than that of the first covering member.

For the thermoelectric conversion module relating to a second implementation of the present invention, in the thermoelectric conversion module relating to the first implementation, the first covering member is formed of a resin mixed with a metal material.

For the thermoelectric conversion module relating to a third implementation of the present invention, in the thermoelectric conversion module relating to the first or second implementation, the second covering member includes a heat insulation material.

For the thermoelectric conversion module relating to a fourth implementation of the present invention, in the thermoelectric conversion module relating to the third implementation, the second covering member is formed of a resin mixed with the heat insulation material.

For the thermoelectric conversion module relating to a fifth implementation of the present invention, in the thermoelectric conversion module relating to any one of the first to fourth implementations, the second covering member covers the plurality of thermoelectric conversion elements and the second electrodes.

### Explanation of Reference Signs

- 1: Thermoelectric conversion module
- 2a: First thermoelectric conversion element
- 2b: Second thermoelectric conversion element
- 3a: First electrode
- 3b: Second electrode
- 4: First covering member
- 4a: Void
- 5: Second covering member
- 6: Support substrate
- 7: External connection part
- 8: External connection part
- 9: Cooling mechanism

## Claims

1. A thermoelectric conversion module (1) comprising:
a plurality of thermoelectric conversion elements (2a, 2b) arranged side by side;
first electrodes (3a) joined to first ends of the thermoelectric conversion elements (2a, 2b) and electrically connecting the first ends of the adjacent thermoelectric conversion elements (2a, 2b) to each other; and
second electrodes (3b) joined to second ends of the thermoelectric conversion elements (2a, 2b) and electrically connecting the second ends of the adjacent thermoelectric conversion elements (2a, 2b) to each other, **characterized by**
a cooling mechanism (9) that cools the first electrodes (3a);
a first covering member (4) that covers the first electrodes (3a) and includes the cooling mechanism (9); and
a second covering member (5) that covers at least part of each of the plurality of thermoelectric conversion elements (2a, 2b) and the second electrode (3b),
wherein the second covering member (5) has a thermal conductivity lower than a thermal conductivity of the first covering member (4).

2. The thermoelectric conversion module (1) according to claim 1,
wherein the first covering member (4) is formed of a resin mixed with a metal material.

3. The thermoelectric conversion module (1) according to claim 1 or 2,
wherein the second covering member (5) includes a heat insulation material.

4. The thermoelectric conversion module (1) according to claim 3,
wherein the second covering member (5) is formed of a resin mixed with the heat insulation material.

5. The thermoelectric conversion module (1) according to any one of claims 1 to 4,
wherein the second covering member (5) covers the plurality of thermoelectric conversion elements (2a, 2b) and the second electrodes (3b).

6. The thermoelectric conversion module (1) according to any one of claims 1 to 5,
wherein the cooling mechanism (9) circulates cooling water to voids (4a) formed in the first covering member (4).

## Patentansprüche

1. Thermoelektrisches Umsetzungsmodul (1), das Folgendes umfasst:
mehrere thermoelektrische Umsetzungselemente (2a, 2b), die nebeneinander angeordnet sind;
erste Elektroden (3a), die mit den ersten Enden der thermoelektrischen Umsetzungselemente (2a, 2b) verbunden sind und die ersten Enden der benachbarten thermoelektrischen Umsetzungselemente (2a, 2b) elektrisch miteinander verbinden; und
zweite Elektroden (3b), die mit den zweiten Enden der thermoelektrischen Umsetzungselemente (2a, 2b) verbunden sind und die zweiten Enden der benachbarten thermoelektrischen Umsetzungselemente (2a, 2b) elektrisch miteinander verbinden; **gekennzeichnet durch**
einen Kühlmechanismus (9), der die ersten Elektroden (3a) kühlt;
ein erstes Abdeckungselement (4), das die ersten Elektroden (3a) abdeckt und den Kühlmechanismus (9) enthält; und
ein zweites Abdeckungselement (5), das zumindest einen Teil von jedem der mehreren thermoelektrischen Umsetzungselemente (2a, 2b) und die zweite Elektrode (3b) abdeckt,
wobei das zweite Abdeckungselement (5) eine Wärmeleitfähigkeit aufweist, die niedriger als eine Wärmeleitfähigkeit des ersten Abdeckungselements (4) ist.

2. Thermoelektrisches Umsetzungsmodul (1) nach Anspruch 1,
wobei das erste Abdeckungselement (4) aus einem Harz gebildet ist, das mit einem Metallmaterial gemischt ist.

3. Thermoelektrisches Umsetzungsmodul (1) nach Anspruch 1 oder 2,
wobei das zweite Abdeckungselement (5) ein Wärmeisolationsmaterial enthält.

4. Thermoelektrisches Umsetzungsmodul (1) nach Anspruch 3,
wobei das zweite Abdeckungselement (5) aus einem Harz gebildet ist, das mit dem Wärmeisolationsmaterial gemischt ist.

5. Thermoelektrisches Umsetzungsmodul (1) nach einem der Ansprüche 1 bis 4,
wobei das zweite Abdeckungselement (5) die mehreren thermoelektrischen Umsetzungselemente (2a, 2b) und die zweiten Elektroden (3b) abdeckt.

6. Thermoelektrisches Umsetzungsmodul (1) nach einem der Ansprüche 1 bis 5,
wobei der Kühlmechanismus (9) bewirkt, dass Kühlwasser zu Hohlräumen (4a) zirkuliert, die im ersten Abdeckungselement (4) gebildet sind.

## Revendications

1. Module de conversion thermoélectrique (1) comprenant :
une pluralité d'éléments de conversion thermoélectrique (2a, 2b) agencés côte à côte ;
des premières électrodes (3a) réunies à des premières extrémités des éléments de conversion thermoélectrique (2a, 2b) et connectant électriquement les premières extrémités des éléments de conversion thermoélectrique adjacents (2a, 2b) les unes aux autres ; et
des secondes électrodes (3b) réunies à des secondes extrémités des éléments de conversion thermoélectrique (2a, 2b) et connectant électriquement les secondes extrémités des éléments de conversion thermoélectrique adjacents (2a, 2b) les unes aux autres,
**caractérisé par**
un mécanisme de refroidissement (9) qui refroidit les premières électrodes (3a) ;
un premier élément de couverture (4) qui couvre les premières électrodes (3a) et qui inclut le mécanisme de refroidissement (9) ; et
un second élément de couverture (5) qui couvre au moins une partie de chacun de la pluralité d'éléments de conversion thermoélectrique (2a, 2b) et la seconde électrode (3b),
dans lequel le second élément de couverture (5) présente une conductivité thermique plus faible qu'une conductivité thermique du premier élément de couverture (4).

2. Module de conversion thermoélectrique (1) selon la revendication 1, dans lequel le premier élément de couverture (4) est formé d'une résine mélangée avec un matériau métallique.

3. Module de conversion thermoélectrique (1) selon la revendication 1 ou 2, dans lequel le second élément de couverture (5) inclut un matériau d'isolation thermique.

4. Module de conversion thermoélectrique (1) selon la revendication 3,
dans lequel le second élément de couverture (5) est formé d'une résine mélangée avec le matériau d'isolation thermique.

5. Module de conversion thermoélectrique (1) selon l'une quelconque des revendications 1 à 4,
dans lequel le second élément de couverture (5) couvre la pluralité d'éléments de conversion thermoélectrique (2a, 2b) et les secondes électrodes (3b).

6. Module de conversion thermoélectrique (1) selon l'une quelconque des revendications 1 à 5,
dans lequel le mécanisme de refroidissement (9) fait circuler l'eau de refroidissement vers des vides (4a) formés dans le premier élément de couverture (4).
